(19) Europäisches Patentamt
European Patent Office
Office européen des brevets

(11) **EP 4 697 016 A1**

(12) **EUROPÄISCHE PATENTANMELDUNG**

(43) Veröffentlichungstag:
**18.02.2026 Patentblatt 2026/08**

(21) Anmeldenummer: **25195473.1**

(22) Anmeldetag: **12.08.2025**

(51) Internationale Patentklassifikation (IPC):
**G01N 24/08** (2006.01) **G01R 33/46** (2006.01)
**G01N 23/223** (2006.01)

(52) Gemeinsame Patentklassifikation (CPC):
**G01N 24/08; G01N 23/223; G01R 33/46**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: **14.08.2024 DE 102024002704**

(71) Anmelder: **Helmholtz-Zentrum Berlin für Materialien und Energie GmbH**
**14109 Berlin (DE)**

(72) Erfinder: **Roß, Marcel**
**12437 Berlin (DE)**

(54) **VERFAHREN ZUR QUANTITATIVEN BESTIMMUNG VON BESTANDTEILEN EINER LÖSUNG**

(57) Die Erfindung betrifft ein Verfahren zur quantitativen Bestimmung von Bestandteilen einer Lösung. Das Verfahren umfasst mindestens die folgenden Schritte:
- Bereitstellen einer Probe,
- Bereitstellen einer Referenzlösung, die mindestens einen ersten Standard in Form einer 1H-NMR aktiven Substanz und einen zweiten Standard in Form eines Metallsalzes eines Metalls mit einer Ordnungszahl $\geq$ 10 umfasst und wobei das Lösungsmittel insbesondere durch eine deuterierte Flüssigkeit gegeben ist,
- Auflösen der gesamten Probe in der Referenzlösung, um eine Analysenlösung zu erhalten,
- Analyse der Analysenlösung mittels 1H-NMR-Spektroskopie und
- Auftragen eins definierten Volumens der Analysenlösung auf einen Träger und Eintrocknen der Analysenlösung und anschließend
- Analyse der eingetrockneten Analysenlösung mit XRF-Spektroskopie,
- Auswertung der in den Analysen gewonnenen Daten.

Das erfindungsgemäße Verfahren ist in vorteilhafter Weise einfach und benötigt nur eine Probennahme. Ein Wiegen der genommenen Probe ist zur Bestimmung der Zusammensetzung nicht erforderlich,

Fig. 1

EP 4 697 016 A1

**Beschreibung**

Die vorliegende Erfindung betrifft ein Verfahren zur quantitativen Bestimmung von Bestandteilen einer Lösung, wie ein solches Verfahren in der chemischen Analytik zum Einsatz kommt.

Die genaue Kenntnis der quantitativen Zusammensetzung von flüssigen oder festen Substanzen spielt in vielen Bereichen der Herstellung von Materialien bzw. Werkstoffen eine entscheidende Rolle. Die Kenntnis über die Zusammensetzung erlaubt z.B. die Optimierung von Abscheideverfahren, die Qualitätskontrolle und das Einhalten von Grenzwerten. Es sind sowohl Festkörper als auch in Lösungen gebrachte feste Stoffe, Gase und Flüssigkeiten für eine chemische Analyse zugänglich. Insbesondere für eine quantitative Analyse ist es dabei mitunter erforderlich, Festkörper in Lösung zu bringen. Die Analyse von Elementen der Fraktionen der leichten und der schweren Elemente einer Probe eines Materials bringt zudem zuweilen das Erfordernis mit, für die jeweilige Fraktion getrennte Verfahren und getrennte Probenaufbereitungen eines Materials durchzuführen.

Die Fraktion der leichten Elemente im Sinne der Erfindung umfasst solche aus denen organische Moleküle überwiegend gebildet sind, d.h., die Gruppe von C, H, O, N, S und P. Die Fraktion der schweren Elemente im Sinne der Erfindung ist gegeben durch alle Elemente ab der vierten Periode. Die Trennung im Sinne der Erfindung ist insbesondere relevant für chemische Stoffe, die organische Kationen und Metallkationen der schweren Fraktion enthalten, für welche Gruppe die erfinderische Methode in besonders vorteilhafter Weise zu verwenden ist. Neben den Metallkationen sind in der schweren Fraktion auch Anionen bestimmbar. Einzelne Elemente der Fraktionen können dabei stellvertretend für organische Kationen bzw. Metallkationen ausgewertet werden.

Eine Probennahme, die lediglich mit geringem Probenvolumen bzw. Probenmasse möglich ist, stellt zusätzliche Ansprüche an das Analyseverfahren, z.B. wenn der Anteil eines nachzuweisenden Elements an sich schon gering ist oder ein Analyseverfahren an sich eine bestimmte Probenmenge erfordert.

Als Probe im Sinne der Erfindung und dieser Beschreibung ist eine abgetrennte bzw. entnommene Menge eines Materials bzw. eines Werkstoffs, dessen Zusammensetzung zu analysieren ist, aufzufassen, was auch als Analysenportion angesprochen werden kann. Eine Probe dient dabei der Repräsentanz für die Zusammensetzung des gesamten Materials bzw. Werkstoffs, in Rohform oder verarbeitet. Eine Probe kann im äußersten Fall auch ein ganzes Werkstück oder ein komplettes, spezielles Teil eines Gegenstandes, wie. z.B. eine aufgetragene Schicht, einer Serienfertigung zur Qualitätskontrolle umfassen.

Ein Analyseverfahren, dem leichte Elemente zugänglich sind ist z.B. die Kernspinresonanz-Spektroskopie auch NMR-Spektroskopie (engl.: Nuclear Magnetic Resonance spectroscopy) genannt, wobei hier insbesondere die 1H-NMR-Spektroskopie zu nennen ist, mit der Wasserstoffkerne zugänglich sind. Die NMR-Spektroskopie benötigt üblicherweise die Proben in Lösung. Die Messsignale beziehen sich dabei stets auf einen internen Standard in der Lösung, in der sich die Probe in gelöstem Zustand befindet. Es wird zur Analyse des Zielelements oder der Zielverbindung (-molekül), z.B. Wasserstoff, die sogenannte chemische Verschiebung gegenüber dem internen Standard bestimmt, wobei über das Integral der Signale eine quantitative Analyse ermöglicht ist. Als Standard kommt z.B. Tetramethylsilan zum Einsatz, oder Restprotonen in einem deuterierten Lösungsmittel. In dem Übersichtsartikel von V. Rizzo und V. Pinciroli (Quantitative NMR in synthetic and combinatorial chemistry, Journal of Pharmaceutical and Biomedical Analysis, Vol. 38, 2005, S. 851-857) sind die grundlegenden Anforderungen, Verfahrensweisen, Anwendungen und Auswertemethoden der quantitativen NMR-Spektroskopie erläutert.

Ein Analyseverfahren, dem schwere Elemente zugänglich sind ist z.B. die RöntgenfluoreszenzAnalyse (RFA), auch XRF (X-Ray Fluorescence) -Spektroskopie genannt. Die RFA gibt es in Abhängigkeit des Bezugs des Röntgenstrahls zu der Probe als Totalreflexions-RFA (T-RFA), Röntgenfluoreszenzanalyse unter streifendem Einfall (engl.: Grazing Incidenc XRF, GIXRF), unter Verwendung eines Röntgenstrahls mit Querschnitt im Mikrometerbereich als $\mu$-RFA und in Durchstrahlgeometrie als Röntgenabsorptionsspektroskopie (engl.: X-ray Absorption Spectroscopy, XAS) unter Verwendung des Fluoreszenzsignals. Für eine quantitative Analyse wird auch hier ein interner Standard oder eine Referenz benötigt. In dem Übersichtsartikel von E. Marguí et al. (X-ray fluorescence spectrometry for environmental analysis: Basic principles, instrumentation, applications and recent trends, Chemosphere, Vol. 303, 2022, 135006- 1-18) sind Anwendung, Instrumentierung, Probenpräparation u.a. Aspekte für die Durchführung und Auswertung der RFA besprochen.

Ein Beispiel des Erfordernisses der quantitativen Analyse der Zusammensetzung eines Materials zur Qualitätskontrolle ist z.B. die Herstellung von Perowskit-Schichten für Perowskit-Solarzellen. Insbesondere hier gibt es den Bedarf der Bestimmung von Elementen aus beiden Fraktionen der leichten und schweren Elemente für Perowskite mit organischen Kationen.

Die Herausforderungen der Analyse der Zusammensetzung von Perowskiten mit gemischten Kationen ist z.B. in dem Aufsatz 1 von C. Pareja-Rivera et al. (On the True Composition of Mixed-Cation Perovskite Films, ACS Energy Letters, Vol. 3, 2018, S. 2366-2367) besprochen. Es kommt hier u.a. NMR-Spektroskopie zum Einsatz. In dem Aufsatz 2 von J. Teuscher et al. (Control and Study of the Stoichiometry in Evaporated Perovskite Solar Cells, ChemSusChem, Vol. 8, 2015, S. 3847 - 3852) ist die gleiche Thematik besprochen, jedoch mit Fokus auf andere Analysetechniken.

Aufgabe der vorliegenden Erfindung ist es ein Verfahren anzugeben, mit dem unter Verwendung von im Vergleich zum Stand der Technik verringerter Probenmenge sowohl sogenannte leichte als auch schwerere Elemente quantitativ bestimmbar sind und dies in vereinfachter Form mit einmaliger Probennahme.

Die Aufgabe ist durch das Verfahren in Anspruch 1 gelöst. Vorteilhafte Ausführungsformen sind Gegenstand der abhängigen Ansprüche.

Es konnte bei der Anmelderin gezeigt werden, dass die Aufgabe der Erfindung durch ein Verfahren, in dem die Aufbereitung einer Probe in einer Lösung mit zwei Standards, jeweils einen für die quantitative Analyse mittels 1H-NMR-Spektroskopie und für die RFA erfolgt, lösbar ist.

Das erfindungsgemäße Verfahren zur quantitativen Bestimmung von Bestandteilen einer Lösung umfasst mindestens die folgenden Schritte.

Von einem zu beprobenden Material oder Werkstück wird eine Probe genommen. Die genommene Probe ist gegebenenfalls für die weitere Verarbeitung im Verfahren aufzubereiten, z.B. zu mörsern. Bei Proben, die aus einem leicht löslichen Material bestehen, entfällt die Aufbereitung. Eine Probe kann im äußersten Fall auch ein ganzes Werkstück oder ein komplettes, spezielles Teil, das eine Einheit bildet, eines Gegenstandes, wie. z.B. eine gesamte aufgetragene Schicht eines Schichtstapels, einer Serienfertigung zur Qualitätskontrolle umfassen. Der Vorteil insbesondere der letzteren Art der Beprobung (ein komplettes spezielles Teil) ist, dass die gewonnenen Informationen auf das gesamte Volumen zu beziehen sind und nicht z.B. nur auf die Oberfläche, oder Teilstücke, die von Inhomogenitäten betroffen sein können.

Weiterhin wird eine Referenzlösung bereitgestellt, die mindestens einen ersten Standard in Form einer 1H-NMR aktiven Substanz und einen zweiten Standard in Form eines Metallsalzes eines Metalls mit einer Ordnungszahl ≥ 10 umfasst und wobei das Lösungsmittel insbesondere durch eine deuterierte Flüssigkeit gegeben ist.

Als Standards für die 1H-NMR sind prinzipiell alle stabilen organischen Verbindungen möglich. Eine Auswahl ist unter folgenden Gesichtspunkten zu treffen:

- Das Protonensignal sollte eine chemische Verschiebung in der Größenordnung der zu analysierenden Probe aufweisen.

- Der Standard darf keine Reaktion mit dem Lösungsmittel oder den zu analysierenden Substanzen eingehen.

- Der Standard muss vollständig lösbar im Lösungsmittel sein.

- Eine Überlagerung der Signale mit denen, der zu analysierenden Probe ist zu vermeiden.

Die Erfüllung der an den Standard zu stellenden Bedingungen ist gegebenenfalls experimentell zu überprüfen.

Der Standard in Form einer 1H-NMR aktiven Substanz kann dabei z.B. durch einen der folgenden Gruppe gegeben sein:
Acetanilid, Benzhydrol, Benzoesäure, (Na)-benzoat, Benzylmethylether, Dibrommethan, Dichlormethan, 1,2-Dichlorethan, Diethylphthalat, 1,4-Dimethoxybenzen, Dimethoxymethan, Dimethylfumarat, 2,2-Dimethylmalonic acid, Dimethylphthalat Dimethylterephthalat, Dimethylsulfon, 1,4-Dinitrobenzene, Diphenylmethan, 1,4-Dioxan, Furmarsäure, Hexamethylcyclotrisiloxan, Kaliumhydrogenphthalat, Maleinsäure, Mesitylen (1,3,5-Trimethylbenzene), Natriumacetat, Tetradecan, Toluol, Trichlorethylen, 1,3,5-Trichloro-2-nitrobenzen, 2,4,5-Trichloropyrimidin, 3,4,5-Trichloropyridin, 2,3,5-Triiodobenzoic acid, 2,4,6-Triiodophenol, 3,4,5-Trimethoxybenzaldehyd, 1,3,5-Trioxan. Insbesondere die Standards Dimethylsulfon und Kaliumhydrogenphtalat, neben anderen, sind besonders vorteilhaft, da diese leicht zu handhaben sind, da ohne Risiken für Gesundheit und Umwelt.

Für die Standards für die RFA gilt zuvorderst, dass diese löslich sind im deuterierten Lösungsmittel, welches für die NMR-Referenzlösung verwendet wird. Der Standard für die RFA, ist z.B. gegeben durch ein lösliches Metall oder ein lösliches Metallsalz, wobei das Metall eine Ordnungszahl ≥ 10 hat, und kann z.B. durch ein Metall oder Metallsalz der folgenden Gruppe gegeben sein: Yttrium, Kupfer, Metall-Sulfat, Metall-Nitrat (außer Bismuth-Nitrat), Metall-Perchlorat (außer Alkali-Perchlorate), Metall-Fluorid (außer Erdalkali-Fluoride). Das Metall (des Metallsalzes oder elementar) ist in Hinblick auf seine Absorptionskanten auf das zu untersuchende Metall in der Probe abzustimmen. Das Metall des Standards darf dem in der Probe zu analysierenden insbesondere nicht entsprechen und muss mindestens eine nicht überlappende Absorptionskante an der angedachten, zu untersuchenden Absorptionskante aufweisen, wobei mindestens eine Absorptionskante des Analyten ebenfalls ohne Überlappungen vorliegen muss. Zudem ist es vorteilhaft ein Metall (des Metallsalzes oder elementar) mit einer Absorptionskante des gleichen Typs, das heißt eine Absorptionskante aus dem gleichen Orbital resultierend, wie die des zu analysierenden Metalls in der Probe, als Standard zu verwenden. Wobei die Lage der Absorptionskanten des Metalls im Standard und dem in der Probe in zu optimierender Weise im Spektrum der für die RFA verwendeten Röntgenstrahlen möglichst nicht weiter als 7 keV entfernt liegt. Die Standardisierung ist dadurch vereinfacht. Eine Übersicht über die Absorptionskanten einer Vielzahl von Elementen ist z.B. in dem Aufsatz 4 von R. D. Deslattes et al. (X-ray transition energies: new approach to a comprehensive evaluation, Reviews Of Modern Physics, Vol. 75, 2003, S. 35 -99) aufgeführt. Auf der Webseite "https://www.nist.gov/pml/x-ray-transitionen ergies-database" (zuletzt abgerufen am 10.06.2024), des National Insitute of Standard and Technology (NIST), U.S. Department of Commerce, Radiation Physics Division, ist die Datensammlung des NIST, zu Röntgenabsorptionskanten einer Vielzahl von Elementen, zugänglich.

Als Lösungsmittel für die Referenzlösung sind prinzipiell alle stabilen deuterierten Lösungsmitte einsetzbar. Eine Auswahl ist unter folgenden Gesichtspunkten zu treffen:

- Es dürfen keine Reaktionen mit den verwendeten Standards oder den zu analysierenden Substanzen stattfinden.

- Sowohl die Standards als auch die Probe müssen vollständig lösbar im Lösungsmittel sein.

- Eine Überlagerung der nicht deuterierten Lösungsmittelsignale mit denen, der zu analysierenden Probe und der Standards ist zu vermeiden.

Das deuterierte Lösungsmittel kann dabei z.B. durch eines der folgenden Gruppe gegeben sein: MeOD (Methanol-$d_4$), EtOD (Ethanol-$d_6$), DMSO (Dimethylsulfoxid-$d_6$), $D_2O$, $CDCl_3$ (Chloroformd), $C_6D_6$ (Benzen-$d_6$), $Me_2CO$ ($CD_3COCD_3$, Aceton-$d_6$), MeCN ($CD_3CN$, Acetonitril-$d_3$), $CD_3COOD$ (Essigsäure-$d_4$).

Die Standards und das Lösungsmittel sowie die darin zu lösende Probe müssen gegebenenfalls aufeinander abgestimmt werden. Hierzu ist es mitunter erforderlich Testlösungen herzustellen und einschlägige Nachschlagwerke zu befragen.

In dem Aufsatz 3 von T. Rundlöf et al. (Survey and qualification of internal standards for quantification by 1H NMR spectroscopy, Journal of Pharmaceutical and Biomedical Analysis, Vol. 52, 2010, S. 645-651) sind häufig verwendete Standards und Lösungsmittel besprochen. Eine Übersicht über NMR-Standards und Löslichkeiten in verschiedenen Lösungsmitteln ist in der Tabelle "AK Hintermann List of qNMR Standards - Version 1.7" abrufbar unter "https://www.ch. nat.tum.de/fileadmin/w00bzu/oca/Ressources/AK_Hintermann_List_of_qNMR_Stan dards.pdf" (abgerufen am 07.06.2024), des Arbeitskreises Prof. Dr. L. Hintermann, Professur für Organische Chemie, TUM School of Natural Sciences, Technische Universität München zu finden.

Die bereitgestellte Probe wird in der bereitgestellten Referenzlösung gelöst. Hierzu sind falls erforderlich Beeinflussungen der Kinetik des Lösevorgangs zur Beschleunigung desselben anzuwenden, wie z.B. Erwärmung und Rühren. Die Probe muss im erfindungsgemäßen Verfahren in vorteilhafter Weise nicht gewogen werden. Durch die Verwendung des doppelten Standards lassen sich die absoluten Massen einer Probe mit Anteilen von Elementen der leichten Fraktion und schweren Fraktion direkt quantifizieren. Dies erfolgt über die Information über die leichte Fraktion einer Verbindung, z.B. organische Kationen in einem Perowskit, zusammen mit der Information über die schwere Fraktion, z.B. die übrigen Kationen wie Blei oder Zinn und die Halogenide z.B. Iodid oder Bromid in einem Perowskit.

An der Analysenlösung wird in einem, durch das 1H-NMR-Spektrometer vorbestimmten Volumen, in einem, ebenfalls durch das 1H-NMR-Spektrometer vorbestimmten Probengefäß eine Analyse mittels 1H-NMR-Spektroskopie durchgeführt. Das Volumen ist zumeist durch das Probengefäß vorgegeben. Als Probengefäße kommen zumeist dünnwandige Glasröhrchen zum Einsatz. Die Durchführung einer 1H-NMR-Spektroskopischen-Analyse ist fachmännisches tun.

1H-NMR-Spektrometer, Probengefäße und Standards sowie Lösemittel sind einschlägig bekannt und käuflich erwerbbar.

Die 1H-NMR-spektroskopische Analyse belässt die Analysenlösung in physikalischer und chemischer Hinsicht unverändert. Eine weitergehende Analyse mit derselben, bereits mit 1H-NMR analysierten Analysenlösung kann wie die 1H-NMR-spektroskopische Analyse direkt auf ein und dieselbe Probe zurückgeführt werden. Es ist folglich nur eine Probennahme nötig.

Die mit 1H-NMR-Spektroskopie analysierte Analysenlösung wird anschließend zur Gänze oder teilweise auf einen Träger aufgebracht, z.B. durch Pipettierung, was in vorteilhafter Weise eine Einstellung des aufgebrachten Volumens ermöglicht. Die aufgebrachte Analysenlösung wird auf dem Träger eingetrocknet. Das Eintrocknen kann an Luft, evakuiert oder durch Erwärmung beschleunigt erfolgen. Auch ein Überströmen mit Luft oder inert Gas ist möglich.

Als Träger für die Verwendung im erfindungsgemäßen Verfahren kommen Gegenstände mit mindestens einer ebenen Oberfläche in Frage, wie z.B. Platten, Plättchen, Discs, Scheiben, Blöcke usw., und wobei die Analysenlösung auf die mindestens eine ebene Oberfläche des Trägers aufgebracht wird. Das Material des Trägers darf kein zu analysierendes Element enthalten und auch keine Elemente, die bei der avisierten Energie der Analyse Absorptionskanten aufweisen. Insbesondere ist der Träger in vorteilhafter Weise aus einem Kunststoff hergestellt. Kunststoffe haben in den Energiebereichen, in denen Metalle mit Ordnungszahl $\geq 10$ absorbieren, einen zu vernachlässigenden Wechselwirkungsquerschnitt, was insbesondere für die T-RFA gilt.

An der eingetrockneten Analysenlösung wird eine Röntgen-Fluoreszenz-Analyse, RFA, insbesondere unter Totalreflexion, T-RFA, durchgeführt. Die T-RFA bietet den Vorteil, dass durch den extrem kleinen Einfallswinkel keine oder nur sehr geringe Anteile eines Trägers mit angeregt werden und somit nicht störend in der Analyse anfallen und vernachlässigbar sind. Für die T-RFA sind Experimentierstationen an Synchrotronstrahlungsquellen, z.B. BESSY II, der Helmholtz-Zentrum Berlin für Materialien und Energie GmbH, einzusetzen, als auch in vorteilhafter Weise Laborgeräte. An Synchrotronstrahlungsquellen steht Röntgenstrahlung über einen weiten Energiebereich (~100 eV bis 50 keV) in ausreichender Intensität und frei durchstimmbar zur Verfügung. Laborgeräte sind gleichfalls verwendbar, wenn die benötigten Energien in ausreichender Intensität erreichbar sind.

Die mit den Analyseverfahren 1H-NMR-Spektroskopie und RFA gewonnene Analysedaten werden nach ihrer Erfassung ausgewertet, um die Informationen über die quantitativen Anteile z.B. organischen Kationen oder Metalle in dem beprobten Material, z.B. einem Perowskit, zu erhalten. Die Ergebnisse sind für die Prozess- und Qualitätskontrolle zu verwenden.

Für die Auswertung kommen die einschlägigen Algorithmen bzw. Softwareprogramme zum Einsatz. Ein Algorithmus für die quantitative Auswertung von 1H-NMR-Spektren ist gegeben durch folgende Formel (1) zur Berechnung einer Stoffmenge, $n_i$, eines fraglichen Analyten:

$$n(Analyt) = \frac{n(Standard) \cdot \frac{Peakfläche(Analyt)}{Anzahlwasserstoffatome(Analyt)}}{\frac{Peakfläche(Standard)}{Anzahlwasserstoffatome(Standard)}} \qquad (1)$$

Ein Algorithmus für die quantitative Auswertung von T-RFA-Spektren ist gegeben durch die Formel (2) zur Berechnung einer Stoffmenge, $n_i$, eines fraglichen Analyten:

$$n(Analyt) = n(Standard) \cdot \frac{Peakfläche(Analyt) \cdot S(Analyt)}{Peakfläche(Standard) \cdot S(Standard)} \qquad (2)$$

S(Analyt) = relative Sensitivität des Analyten, S(Standard) = relative Sensitivität des Standards. Eine Auswahl von Sensitivitäten sind z.B. in dem Aufsatz 5 von E. Towett et al. (Quantification of total element concentrations in soils using total X-ray fluorescence spectroscopy (TXRF), Science of the Total Environment, Vol. 463-464, 2013, S. 374-388) aufgelistet und üblicherweise in den käuflich erwerbbaren Vorrichtungen für die Durchführung von T-XRF hinterlegt zur Verwendung mit geräteeigener Software.

Für die Bestimmung der absoluten Zusammensetzung einer Probe, ohne diese zu wiegen, müssen die Stoffmengen bzw. Massen aller Elemente bzw. Verbindungen, der leichten und schweren Fraktion bestimmt werden. Bei Kenntnis der leichten Fraktion einer Verbindung, z.B. organische Kationen in einem Perowskit, zusammen mit der Information über die schwere Fraktion, z.B. die übrigen Kationen wie Blei oder Zinn und die Halogenide z.B. Iodid oder Bromid in einem Perowskit kann dann eine Summenformel erstellt werden. Zudem ist über die Summe aller einzelnen Massen auch die Gesamtmasse der Probe zugänglich.

Die gewonnen Informationen stehen nach der Analyse z.B. für die Optimierung von Herstellungsprozessen zur Verfügung.

Mit dem erfinderischen Verfahren ist eine Analyse sowohl der Elemente der leichten Fraktion als auch der schweren Fraktion in einfacher und sparsamer Weise und mit geringem Probenmaterial ermöglicht und benötigt zudem kein Einwiegen des Probenmaterials.

In einer Ausführungsform des erfindungsgemäßen Verfahrens zur quantitativen Bestimmung von Bestandteilen einer Lösung ist die 1H-NMR aktive Substanz Dimethylsulfon.

In einer weiteren Ausführungsform des erfindungsgemäßen Verfahrens zur quantitativen Bestimmung von Bestandteilen einer Lösung ist das Metallsalz Nickelnitrat-Hexahydrat, $Ni(NO_3)_2 \cdot 6\,H_2O$.

Die beiden Ausführungsformen sind in vorteilhafter Weise miteinander zu kombinieren.

**Beispiel**

Die Erfindung in beispielhafter Ausführung wird im Folgenden durch ein Beispiel für das erfindungsgemäße Verfahren zur quantitativen Bestimmung von Bestandteilen einer Lösung und 2 Figuren näher beschrieben.

Die Figuren zeigen:

Fig. 1: 1H-NMR-Spektrum der Analysenlösung des Ausführungsbeispiels.

Fig. 2: RFA-Spektrum der selben Analysenlösung wie in Fig. 1, im eingetrockneten Zustand,

Im Ausführungsbeispiel ist die Referenzlösung gegeben durch deuteriertes Dimethylsulfoxid (D6-DMSO) als Lösungsmittel und Dimethylsulfon als 1H-NMR aktive Substanz (Standard) und Nickelnitrat-Hexahydrat, $Ni(NO_3)_2 \cdot 6$

$H_2O$, als Standard für die RFA. Die Konzentration des 1H-NMR-Standards Dimethylsulfon beträgt 3,378 mmol/l. Die Konzentration des Nickelnitrat-Hexahydrat Standards beträgt 7,594 mmol/l, was einer Konzentration an Nickel von 0,28 mg/ml entspricht.

Im Beispiel ist das zu beprobende Material ein Perowskit, welcher auf einen Schichtstapel zur Herstellung einer Perowskit-Solar-Zelle abgeschieden ist. Bei dem Perowskit handelt es ich um einen Formaidinium Cäsium Blei Iodid Bromid - Perowskit mit der formalen Zusammensetzung $Cs_aFA_bPbI_xBr_y$. Der Perowskit ist auf einem mit Indiumzinnoxid und Lochkontaktschicht beschichtetem 5 cm mal 2,5 cm großen Glassubstrat mit einer Schichtdicke von ca. 550 nm durch Ko-Verdampfung abgeschieden. Der abgeschiedene Perowskit wird durch mehrfache Extraktion mit einem definierten Volumen der Referenzlösung (siehe oben) von dem Schichtstapel abgelöst. Die gewonnenen Analysenlösung enthält nun das gesamte Probenmaterial, d.h. die gesamte Perowskitschicht, in einem definierten Volumen von z.B. 1 ml. Das Lösen der gesamten Probe verhindert fehlerhafte Beprobung, die durch lokal begrenzte Inhomogenitäten bedingt sind. Die Ermöglichung dieser Art der Probennahme ist ein Vorteil der Erfindung.

Von der Analysenlösung werden 0.6 ml in ein 5 mm NMR-Präzisionsröhrchen gegeben. Die Analysenlösung im Ausführungsbeispiel wird in einem gebräuchlichen 500 MHz-Spektrometer (AVANCE III) der Firma Bruker analysiert.

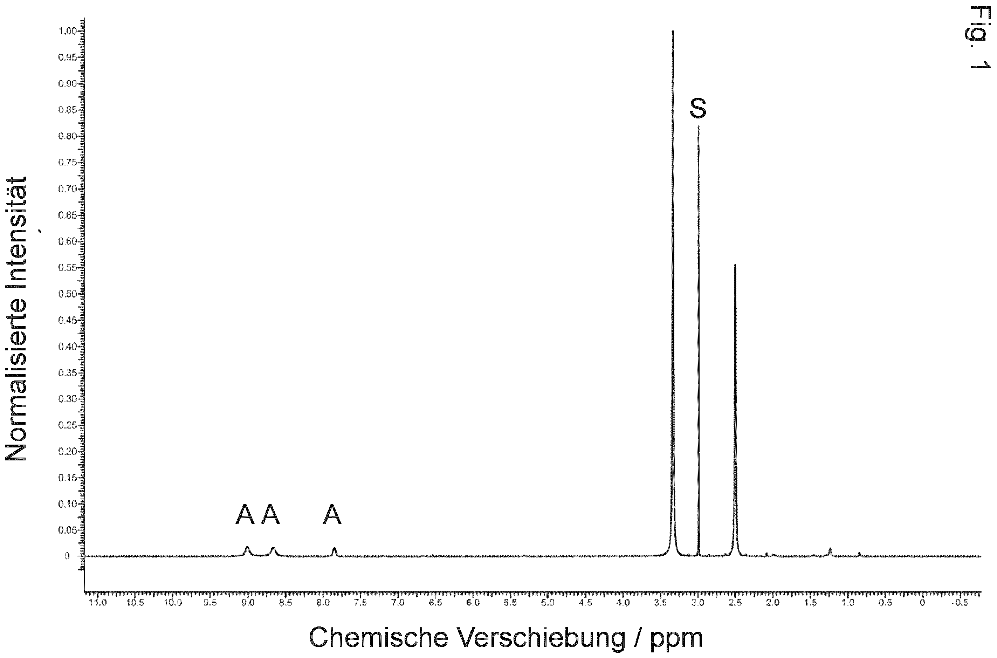

In Fig. 1 ist das 1H-NMR-Spektrum der Analysenlösung des Beispiels gezeigt. Markiert sind die Signale des Analyten (Formamidinium, $FA^+$), A, zwischen 9,5 und 7,5 ppm und das Signal des Standards (Dimethylsulfon), S, bei 3 ppm. Zur Auswertung werden die Signale der entsprechenden C-H Funktionen bzw. der $NH_2/NH_2^+$ Gruppen integriert. Über einen einfachen Dreisatz ergibt sich aus dem Vergleich der auf die Anzahl der beteiligten Wasserstoffatome normierten Integrale des Analyten und des Standards mit Hilfe der bekannten Stoffmenge des Standards direkt die Stoffmenge des Analyten. Prinzipiell können sowohl das Signal der C-H Funktionen als auch die Signale der $NH_2/NH_2^+$ Gruppen zur Quantifizierung genutzt werden, aufgrund von Austauschprozessen die zur Peakverbreiterung der $NH_2/NH_2^+$ Signale führen ist aber die Verwendung des C-H Signals präferiert. Zur Berechnung der Stoffmenge des fraglichen Analyten, $n_i$, erfolgt die Auswertung gemäß Formel (1), in dem für den Analyten der Wasserstoff stellvertretend genommen wird, unter Annahme einer idealen Zusammensetzung des organischen Kations FA:

Im Ausführungsbeispiel ergibt sich:

$$n(FA^+) = \frac{3,378\,\frac{mmol}{l} \cdot 1\,ml \cdot \frac{1}{1}}{\frac{4,38}{6}} = 0,004627\,mmol$$

Über die molare Masse (45,07 g/mol) ist damit auch die Masse an $FA^+$ in der genommenen Probe zugänglich, welche sich zu 209 mg ergibt.

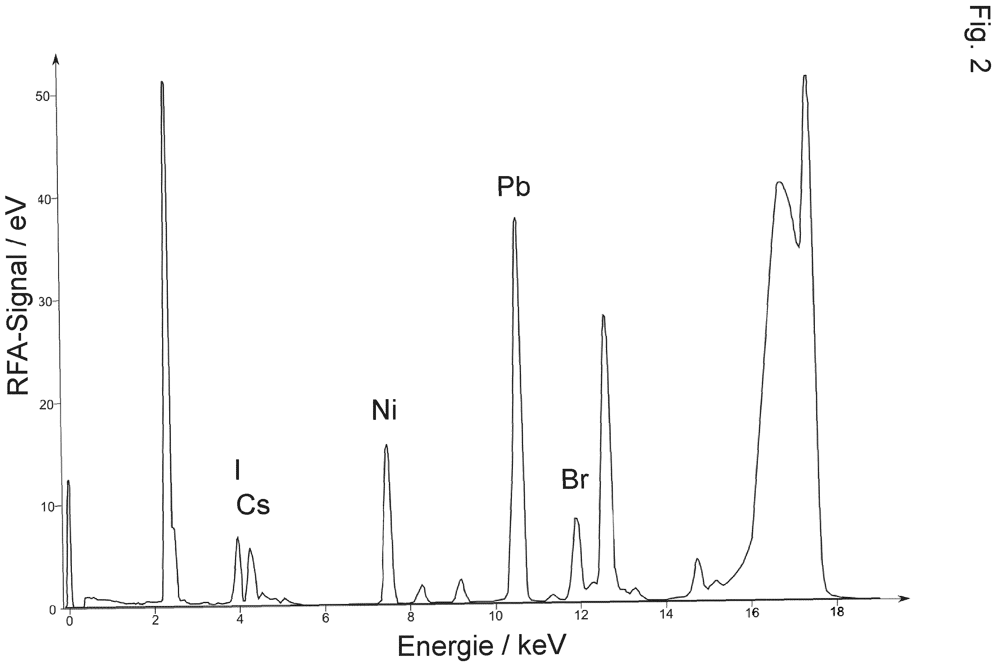

Von derselben Analysenlösung, die für die 1H-NMR-Analytik verwendet wurde, werden 0,015 ml auf einen Acrylglas-Probenträger pipettiert und an Luft eingetrocknet. Da die Analysenlösung während der 1H-NMR Messung unverändert bleibt, kann sowohl die bereits untersuchte als auch die nicht für die 1H-NMR Messung genutzte Analysenlösung für die RFA verwendet werden. Die RFA wird mit einer Molybdän-Anregung im Totalreflektionsmodus, T-RFA, durchgeführt. Das T-RFA-Spektrum ist in der Fig.2 gezeigt. Deutlich zu erkennen ist das Signal des Nickel-Standards zwischen 7.5 und 8,5 keV und die Charakteristischen Linien der zu quantifizierenden Elemente, I, Br, Cs, Pb, die für die Auswertung verwendet wurden. Aus der Konzentration von 0,28 mg/ml Nickel ergibt sich bei einem Volumen von 0,015 ml eine Masse von 4201 ng Nickel pro Probenträger. Diese Masse kann direkt genutzt werden um auf Basis der Formel (2) mit Hilfe der auf dem verwendeten T-RFA-Gerät (Bruker S4 T-STAR) installierten Software, die Stoffmenge bzw. die Massen der zu bestimmenden Elemente (Br, I, Cs, Pb) zu ermitteln. Die Auswertung ergibt, dass sich 14140 ng Blei, 1011 ng Cäsium, 28620 ng Iod und 1363 ng Brom auf dem Probenträger befinden. Da für die T-RFA nur geringste Mengen Analysenlösung beprobt werden, empfiehlt es sich mehrere Messungen durchzuführen, um die Messunsicherheit zu verringern.

Für die Perowskit Probe des Beispiels ergeben sich insgesamt unter Berücksichtigung der Verdünnung für die T-RFA (1 ml zu 0,015 ml) folgende Massen auf der Probe: 0,943 mg Blei, 1.908 mg Iod, 0.0674 mg Cäsium, 0.0909 mg Brom und 0,209 mg $FA^+$. Das entspricht einer Zusammensetzung, dargestellt in der auf Blei normierten Summenformel, von $Cs_{0.11}FA_{1.02}PbI_{3.30}Br_{0.25}$.

Wie im Beispiel gezeigt, ist das erfindungsgemäße Verfahren in vorteilhafter Weise einfach und benötigt nur eine Probennahme. Ein Wiegen der genommenen Probe ist zur Bestimmung der Zusammensetzung nicht erforderlich, was einen Vorteil der Erfindung ausmacht.

**Patentansprüche**

1. Verfahren zur quantitativen Bestimmung von Bestandteilen einer Lösung, welches mindestens die folgenden Schritte umfasst:

- Bereitstellen einer Probe,
- Bereitstellen einer Referenzlösung, die mindestens einen ersten Standard in Form einer 1H-NMR aktiven Substanz und einen zweiten Standard in Form eines Metallsalzes eines Metalls mit einer Ordnungszahl $\geq$ 10 umfasst und wobei das Lösungsmittel insbesondere durch eine deuterierte Flüssigkeit gegeben ist,
- Auflösen der gesamten Probe in der Referenzlösung, um eine Analysenlösung zu erhalten,
- Analyse der Analysenlösung mittels 1H-NMR-Spektroskopie und
- Auftragen eins definierten Volumens der Analysenlösung auf einen Träger und Eintrocknen der Analysenlösung und anschließend
- Analyse der eingetrockneten Analysenlösung mit XRF-Spektroskopie,
- Auswertung der in den Analysen gewonnenen Daten.

2. Verfahren zur quantitativen Bestimmung von Bestandteilen einer Lösung nach Anspruch 1, **dadurch gekennzeichnet, dass**
die 1H-NMR aktive Substanz Dimethylsulfon ist.

3. Verfahren zur quantitativen Bestimmung von Bestandteilen einer Lösung nach Anspruch 1, **dadurch gekennzeichnet, dass**
das Metallsalz Nickelnitrat-Hexahydrat, $Ni(NO_3)_2 \cdot 6 H_2O$, ist.

4. Verfahren zur quantitativen Bestimmung von Bestandteilen einer Lösung nach Anspruch 1, **dadurch gekennzeichnet, dass**
die Probe ein Perowskit ist.

Fig. 1

Fig. 2

**EUROPÄISCHER RECHERCHENBERICHT**

Europäisches Patentamt
European Patent Office
Office européen des brevets

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | FIGUEIREDO FILIPE ET AL: "Fast, accessible and reliable method for elemental analysis of metals in solution by ED-XRF spectroscopy", JOURNAL OF ANALYTICAL SCIENCE AND TECHNOLOGY, Bd. 15, Nr. 1, 7. Mai 2024 (2024-05-07), Seiten 29-11, XP093350717, ISSN: 2093-3371, DOI: 10.1186/s40543-024-00442-4 * das ganze Dokument * ----- | 1-4 | INV. G01N24/08 G01R33/46 G01N23/223 |
| A,D | PAREJA-RIVERA CARINA ET AL: "On the True Composition of Mixed-Cation Perovskite Films", ACS ENERGY LETTERS, Bd. 3, Nr. 10, 11. September 2018 (2018-09-11), Seiten 2366-2367, XP093350474, American Chemical Society ISSN: 2380-8195, DOI: 10.1021/acsenergylett.8b01577 * das ganze Dokument * ----- | 1-4 | |
| A | MA LIN ET AL: "A- or X-site mixture on mechanical properties of APbX3 perovskite single crystals", APL MATERIALS, AMERICAN INSTITUTE OF PHYSICS, 2 HUNTINGTON QUADRANGLE, MELVILLE, NY 11747, Bd. 9, Nr. 4, 22. April 2021 (2021-04-22), XP012255891, DOI: 10.1063/5.0015569 [gefunden am 2021-04-22] * section "Experimental Methods" * ----- -/-- | 1-4 | RECHERCHIERTE SACHGEBIETE (IPC) G01R G01N |

Der vorliegende Recherchenbericht wurde für alle Patentansprüche erstellt

| Recherchenort | Abschlußdatum der Recherche | Prüfer |
|---|---|---|
| München | 8. Januar 2026 | Skalla, Jörg |

EPO FORM 1503 03.82 (P04C03)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

Seite 1 von 2

Europäisches
Patentamt

European
Patent Office

Office européen
des brevets

**EUROPÄISCHER RECHERCHENBERICHT**

**Nummer der Anmeldung**

**EP 25 19 5473**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | ALLEGRETTA IGNAZIO ET AL: "Implementing light elements detection and quantification in aluminosilicate materials using a Low-Z total-reflection X-ray fluorescence spectrometer", APPLIED CLAY SCIENCE, Bd. 251, 5. März 2024 (2024-03-05), Seite 107326, XP093350733, AMSTERDAM, NL ISSN: 0169-1317, DOI: 10.1016/j.clay.2024.107326 * das ganze Dokument * ----- | 1 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 8. Januar 2026 | Skalla, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **V. RIZZO ; V. PINCIROLI**. Quantitative NMR in synthetic and combinatorial chemistry. *Journal of Pharmaceutical and Biomedical Analysis*, 2005, vol. 38, 851-857
- **E. MARGUÍ et al.** X-ray fluorescence spectrometry for environmental analysis: Basic principles, instrumentation, applications and recent trends. *Chemosphere*, 2022, vol. 303, 135006-1, 18
- **C. PAREJA-RIVERA et al.** On the True Composition of Mixed-Cation Perovskite Films. *ACS Energy Letters*, 2018, vol. 3, 2366-2367
- **J. TEUSCHER et al.** Control and Study of the Stoichiometry in Evaporated Perovskite Solar Cells. *ChemSusChem*, 2015, vol. 8, 3847-3852
- **R. D. DESLATTES et al.** X-ray transition energies: new approach to a comprehensive evaluation. *Reviews Of Modern Physics*, 2003, vol. 75, 35-99
- **T. RUNDLÖF et al.** Survey and qualification of internal standards for quantification by 1H NMR spectroscopy. *Journal of Pharmaceutical and Biomedical Analysis*, 2010, vol. 52, 645-651
- **E. TOWETT et al.** Quantification of total element concentrations in soils using total X-ray fluorescence spectroscopy (TXRF). *Science of the Total Environment*, 2013, vol. 463 (464), 374-388